(19) Europäisches Patentamt

European Patent Office

Office européen des brevets

(11) **EP 1 117 285 B1**

(12) **EUROPÄISCHE PATENTSCHRIFT**

(45) Veröffentlichungstag und Bekanntmachung des Hinweises auf die Patenterteilung:
**23.04.2003 Patentblatt 2003/17**

(51) Int Cl.⁷: **H05K 9/00**

(21) Anmeldenummer: **01100345.6**

(22) Anmeldetag: **05.01.2001**

(54) **Arbeitsplatz**

Workstation

Poste de travail

(84) Benannte Vertragsstaaten:
**AT BE CH CY DE DK ES FI FR GB GR IE IT LI LU MC NL PT SE TR**

(30) Priorität: **11.01.2000 DE 10000714**

(43) Veröffentlichungstag der Anmeldung:
**18.07.2001 Patentblatt 2001/29**

(73) Patentinhaber: **Kabelwerk Eupen AG**
**4700 Eupen (BE)**

(72) Erfinder: **Kirschvink, Manfred, Dipl.-Ing.**
**4730 Raeren-Hauset (BE)**

(74) Vertreter: **Bauer, Dirk, Dipl.-Ing. Dipl.-Kfm.**
**Bauer & Bauer,**
**Patentanwälte,**
**Am Keilbusch 4**
**52080 Aachen (DE)**

(56) Entgegenhaltungen:
**DE-A- 3 941 915       DE-A- 19 909 569**
**FR-A- 2 777 689       GB-A- 2 020 476**

**EP 1 117 285 B1**

## Beschreibung

Die Erfindung betrifft einen Arbeitsplatz mit mindestens einem Gerät in Form eines Computers, eines Bildschirms, eines Peripheriegeräts und/oder eines ISDN-Telefons, wobei mindestens eine zu einem Gerät führende Datenleitung vorhanden ist, über die Daten einer Frequenz von mindestens 10 MHz übertragbar sind.

Derartige sogenannte Computer-Arbeitsplätze finden stetig zunehmende Verbreitung, und zwar insbesondere in Büros, aber sehr häufig auch in Verkaufs- und Produktionsstätten sowie bei Serviceeinrichtungen. Der Computer, der Bildschirm und die Peripheriegeräte, wie beispielsweise ein Drucker, Scanner oder Telefaxgerät, sind mit Hilfe von Versorgungsleitungen in der Regel über Steckdosen an das elektrische Netz angeschlossen. Es handelt sich in der Regel um Geräte der Schutzklasse 1 mit einem zugänglichen metallischen Chassis, das über die Versorgungsleitung mit Hilfe eines sogenannten Schutzleiters geerdet ist. Bei einem Laptop handelt es sich um ein Gerät der sogenannten Schutzklasse 2, dessen Versorgungsleitung keinen Schutzleiter aufweist und mit einem zweipoligen, sogenannten Euro-Stecker versehen ist. Das meist vorhandene ISDN-Telefon ist ein Niederspannungsgerät und wird über die Datenleitung mit Strom versorgt.

Bei vernetzten Arbeitsplätzen ist der Computer bzw. der Laptop an ein Computernetzwerk, ein sogenanntes LAN (Local Area Network), angeschlossen, welches alle miteinander kommunizierenden Geräte untereinander verbindet. Über dieses LAN kommunizieren die Computer mit einem sogenannten Server, der die von den Computern generierten Daten in dem Netz verteilt und seinerseits unter Umständen mit einem Server an einem anderen Standort in Verbindung steht.

Der Bürogestaltung werden aufgrund der LAN-Struktur viele Möglichkeiten der flexiblen Anordnung von Computer-Arbeitsplätzen eröffnet. So ist das LAN mit speziellen "Steckdosen", sogenannten "Transmission Outlets" (TO), ausgerüstet, die sich im Fußboden oder in der Nähe der Fußleisten in einer Wand des Büroraums befinden. Mit Hilfe einer flexiblen Datenleitung, die beiderseits mit geeigneten Steckern versehen ist, wird der PC auf einfache, jederzeit reversible Weise mit der TO und somit mit dem LAN verbunden. Eine solche Datenleitung, die oftmals "Patchcord" genannt wird, besitzt eine Länge von ca. 6 bis 10 m und weist üblicherweise Leitungen mit jeweils vier Leiterpaaren auf. Dabei gibt es Ausführungen sowohl ohne als auch mit einer die Leitungen ummantelnden elektrischen Abschirmung, mit der sowohl Störungen infolge von äußeren Feldern als auch eine Abstrahlung der Leitung selbst vermieden werden sollen.

Diese Abschirmung wird über ein metallisches Gehäuse der Stecker des Patchcords mit dem Chassis des Computers einerseits und der Abschirmung des LAN-Kabels andererseits verbunden.

Das LAN überträgt Daten mit hoher Geschwindigkeit, d.h. mit einer hohen Bitrate (Zeichen pro Sekunde); ein typischer Wert liegt zur Zeit bei 100 MBit/s.

ISDN-Telefone sind üblicherweise mit einer flachen vieradrigen, nicht abgeschirmten Leitung an das Telefonnetz des Gebäudes angeschlossen. Die Länge von der Telefondose bis zum Gerät beträgt üblicherweise zwischen 6 und 10 m. Die Datenübertragung erfolgt ebenfalls impulsförmig, d.h. in Form von digital kodierten Signalen. Die Übertragungsgeschwindigkeit beträgt üblicherweise 144 kBit/s.

Sowohl das LAN als auch das ISDN-Netzwerk sind für eine symmetrische Signal- bzw. Datenübertragung konzipiert. Eine symmetrische Übertragung benutzt üblicherweise zwei verdrillte Leiter (d.h. ein Leiterpaar) als Übertragungsweg. Durch die kurze Verdrillung der Leiter, wie dies bei den LAN-Leitungen der Fall ist, weisen die Paare eine sehr geringe elektromagnetische Abstrahlung auf. Die flache vieradrige Leitung des ISDN-Telefons weist eine derartige Verdrillung nicht auf, weshalb hier die Abstrahlung insofern nicht so stark unterdrückt wird.

Auch wenn Computer und Peripheriegeräte nach dem Stand der Technik die international normierten Anforderungen an die sogenannte elektromagnetische Verträglichkeit (EMV) erfüllen, d.h. einen Grenzwert für eine (aktive) Abstrahlung nicht überschreiten, so hat es sich herausgestellt, daß oftmals von derartigen Computer-Arbeitsplätzen unerwünschte Beeinträchtigungen des Wohlbefindens und der Gesundheit der dort arbeitenden Personen ausgehen.

Zum Stand der Technik zählen Ferritringe bzw. Ferritzylinder insbesondere an den sogenannten Videokabeln, die den Bildschirm mit dem Computer verbinden. Ferrit ist ein magnetischer Werkstoff, der seine magnetischen Eigenschaften bis zu hohen Frequenzen behält. Der auf eine Leitung aufgeschobene Ferritring stellt für eine sich hier fortpflanzende Hochfrequenzwelle eine Impedanzänderung, d.h. eine Stoßstelle, dar, an der die auftreffende Welle hauptsächlich reflektiert wird, d.h. wieder zur Quelle zurückläuft. Daraus resultiert eine Verschiebung der Resonanzfrequenzen, die unter anderem durch die Länge des Videokabels bestimmt ist. Durch die Verschiebung der Resonanzfrequenzen gelingt es, die Vorschriften zur elektromagnetischen Verträglichkeit (z. B. nach Norm EN 55022) einzuhalten.

Durch die am Ferritring auftretenden Reflexionen kommt es jedoch zu keiner nennenswerten Vernichtung der elektromagnetischen Energie, so daß mit Hilfe eines derartigen Bauteils die elektromagnetische Abstrahlung bei Betrachtung des gesamten Frequenzspektrums nicht verbessert werden kann.

Der Erfindung liegt die Aufgabe zugrunde, einen Computer-Arbeitsplatz vorzuschlagen, bei dem eine mögliche gesundheitliche Beeinträchtigung der dort arbeitenden Personen durch elektromagnetische Abstrahlung vermindert wird.

Ausgehend von einem Arbeitsplatz der eingangs beschriebenen Art, wird diese Aufgabe erfindungsgemäß dadurch gelöst, daß mindestens eine Datenleitung und/oder mindestens eine Versorgungsleitung eine mantelförmige Beschichtung aus mindestens einem Material aufweist, wobei das Produkt $\varepsilon_r$ x $\mu_r$ x d aus Dielektrizitätszahl $\varepsilon_r$ des Materials, Permeabilitätszahl $\mu_r$ des Materials und Dicke d der Beschichtung im gesamten Frequenzbereich von Hochfrequenz-Gleichtaktströmen von 1 MHz bis 1 000 MHz größer als 30 mm ist.

Es hat sich herausgestellt, daß sich bei einer Datenübertragung nach dem Stand der Technik sowohl im LAN als auch im ISDN-Netz eine sogenannte Gleichtaktkomponente ausbildet, die einerseits durch eine nicht vollkommen symmetrische Ansteuerung durch den Computer bzw. den Server oder die ISDN-Anlage und andererseits durch kleinere Unsymmetrien in den Leitungen selbst hervorgerufen werden. Die Gleichtaktkomponente betrifft entweder alle Leiter einer nicht abgeschirmten Leitung (als Summenstrom) oder bei einer abgeschirmten Leitung die Abschirmung selbst. Als Gegenelektroden zur Rückführung des Gleichtaktstroms werden in Gebäuden nahezu immer vorhandene metallische Strukturen in Form von Moniereisen, Heizungssystemen, Lüftungssystemen oder üblichen Netzleitungen benutzt. Dieser Gleichtaktstrom führt zum Aufbau eines elektromagnetischen Feldes und zu einer elektromagnetischen Abstrahlung.

Dieses Feld ist um so ausgedehnter, je weiter die Datenleitungen bzw. Versorgungsleitungen von der jeweiligen Gegenelektrode geführt werden, d.h. vom Boden des Raums mit integrierten Moniereisen auf die Höhe eines Schreibtischs oder Pults, auf dem der Computer, der Bildschirm oder das Telefon steht. Diese "freie" Länge vom Boden des Raums bis zum jeweiligen Gerät beträgt üblicherweise 0,8 bis 1,5 m und befindet sich immer in der Nähe der genannten Geräte und somit üblicherweise auch in der Nähe ihres Benutzers.

In der Nähe des Benutzers des Computer-Arbeitsplatzes baut sich somit ein elektromagnetisches Feld auf, das ein großes Frequenzspektrum beinhaltet, da die Gleichtaktströme von verschiedenen Quellen hervorgerufen werden.

Die Datenübertragung im LAN und Telefonnetz basiert auf Impulsen mit sehr kurzer Anstiegszeit, die typischerweise ca. 20 ns betragen. In Verbindung mit den bereits erwähnten Impulsübertragungsraten zwischen ca. 144 kBit/s und 100 MBit/s reicht das Frequenzspektrum der Gleichtaktströme je nach Quelle also von ca. 50 Hz bis ca. 1 000 MHz.

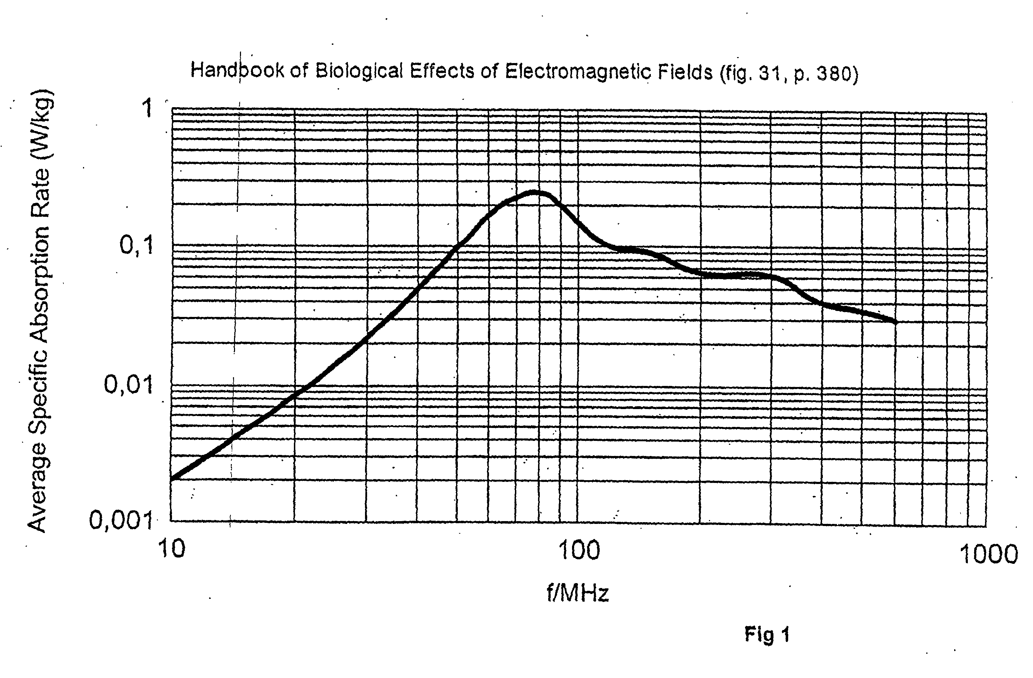

Es ist bekannt, daß der menschliche Körper auf derartige elektromagnetische Felder reagiert. Fig. 1 zeigt eine Empfindlichkeitskurve des menschlichen Körpers in Abhängigkeit von der Frequenz. Auf der Ordinate der Graphik ist ein spezifischer Absorptionsgrad des Körpers ("Specific Absorption Rate") in W/kg Körpergewicht aufgetragen. Wie sich der Graphik entnehmen läßt, steigt der spezifische Absorptionsgrad mit der Frequenz an, erreicht bei ca. 70 MHz ein Maximum, um in Richtung höherer Frequenz wiederum abzufallen.

Betrachtet man nun die "freie" Länge der Datenleitung bzw. der Versorgungsleitung als Antennenlänge, so wäre eine derartige Antenne auf Frequenzen von ca. 90 MHz ( rund 0,8 m) bis ca. 50 MHz ( rund 1,5 m) abgestimmt. Diese Betrachtungsweise ist durchaus berechtigt, da hochfrequenzmäßig der Computer oder das Telefon als Sender zu betrachten sind und hochfrequenzmäßig des weiteren keine feste Erdung dieser Geräte vorliegt. Wie sich mit Blick auf Fig. 1 feststellen läßt, stimmen die Resonanzfrequenzen dieser Leitungslängen, wie sie in der Praxis vorkommen, genau mit dem Gebiet des maximalen Absorptionsgrads des menschlichen Körpers überein.

Hier setzt der erste Effekt der Erfindung ein, denn aufgrund der Beziehung

$$f = \frac{c}{\lambda \sqrt{\varepsilon_r \cdot \mu_r}}$$

mit

f = Frequenz
c = Lichtgeschwindigkeit
$\lambda$ = Wellenlänge
$\varepsilon_r$ = Dielektrizitätszahl
$\mu_r$ = Permeabilitätszahl

sinkt die Resonanzfrequenz der als Antenne anzusehenden Datenleitung bzw. Versorgungsleitung deutlich durch den Einfluss des hohen Produktes $\varepsilon_r$ x $\mu_r$ der mantelförmigen Beschichtung und wird somit aus dem Absorptionsmaximum des menschlichen Körpers verschoben. Ist das Produkt aus $\varepsilon_r$ x $\mu_r$ somit beispielsweise 100, wird die Resonanzfrequenz der Gleichtaktströme um den Faktor 10, d.h. beispielsweise von ehemals 100 MHz auf 10 MHz, reduziert. Wie sich aus Fig. 1 ergibt, kann die spezifische absorbierte Strahlungsleistung des menschlichen Körpers dadurch um mehr als den Faktor 10 reduziert werden.

Der zweite Wirkungsmechanismus der Erfindung besteht darin, daß durch die Beschichtung hohe elektromagnetische Verluste auftreten, da das elektromagnetische Feld zum Teil in dieser Beschichtung liegt. Die Hochfrequenzenergie wird dabei absorbiert und in Wärme umgewandelt. Bei niedrigen Frequenzen bis ca. 50 MHz sind die dielektrischen Verluste maßgeblich, während bei Frequenzen oberhalb von 50 MHz magnetische Verluste im Vordergrund stehen. Das Wirkungsspektrum der Beschichtung ist auch für sehr hohe Übertragungsfrequenzen über 1 GHz wirksam und somit für Datennetze mit sehr hohen Bitraten (600 MBit/s oder mehr) geeignet. Die größte Absorption tritt an den Leitungsstücken auf, die in der Nähe von elektrisch leitenden, geerdeten Strukturen liegen, was beispielsweise der Fall ist, wenn die Leitungen unter dem Fußboden, also in der Nähe der Moniereisen einer Betondecke, liegen.

Mit der erfindungsgemäßen Beschichtung auf der Datenleitung bzw. Versorgungsleitung wird somit zum einen eine Verschiebung des Frequenzbereichs der Abstrahlung weit aus dem Absorptionsmaximum des menschlichen Körpers hinaus bewirkt, wobei dieser Effekt durch die Absorptionswirkung der Beschichtung im Hochfrequenzbereich und somit einer breitbandigen Bedämpfung der "Antenne" noch verbessert wird. Besonders vorteilhaft ist die Verwendung eines Beschichtungsmaterials, dessen Produkt $\varepsilon_r \times \mu_r$ möglichst groß, vorzugsweise über den gesamten relevanten Frequenzbereich größer als 50, besser noch größer als 100 ist, da die Beschichtungsdicke dann um so kleiner gewählt werden kann. Große Beschichtungsdicken führen zu einer unerwünschten Inflexibilität der Leitung.

Gemäß einer Ausgestaltung des erfindungsgemäßen Arbeitsplatzes wird vorgeschlagen, daß die Datenleitung und/oder die Versorgungsleitung von einer gebäudefesten Anschlußstelle bis zu dem Gehäuse des Computers, des Bildschirms, des Peripheriegeräts oder des ISDN-Telefons durchgängig mit der Beschichtung versehen ist, da hierdurch eine größtmögliche Verringerung der elektromagnetischen Abstrahlung erreicht werden kann.

Vorteilhafterweise enthält die Beschichtung Ferrit, da dieses Material eine sehr große Permeabilität aufweist ($\mu_r >$1 000).

Eine aus produktionstechnischer Sicht zu bevorzugende Weiterbildung der Erfindung besteht darin, daß die Beschichtung aus Ferritpartikeln besteht, die in eine Kunststoffmatrix eingebettet sind. Vorteilhafterweise besteht die Kunststoffmatrix aus PVC, PE oder thermoplastischer Elastomeren (TPE), wodurch in Verbindung mit Ferritpartikeln gut zu verarbeitende Compounds entstehen.

Aus produktionstechnischer Sicht ist es zu bevorzugen, wenn die Beschichtung im Wege der Extrusion aufgebracht ist.

Grundsätzlich ist die Wirkungsweise der Abstrahlungsreduzierung sowohl bei abgeschirmten als auch nicht abgeschirmten Datenleitungen wirksam. Sofern abgeschirmte Datenleitungen verwendet werden, bietet dies den Vorteil, daß die Anforderungen an die EMV-Normen leichter erfüllt werden können.

Die Erfindung weiter ausgestaltend, ist vorgesehen, daß bei Verwendung abgeschirmter Datenleitungen die Beschichtung unter Druck auf die Hohlräume aufweisende metallische Abschirmung aufgebracht ist und dabei die Hohlräume zumindest zum Teil ausfüllt.

Die Erfindung wird nachfolgend anhand zweier Ausführungsbeispiele eines Computer-Arbeitsplatzes, die in der Zeichnung dargestellt sind, näher erläutert. Es zeigt:

| | |
|---|---|
| Fig. 2 | einen Computer-Arbeitsplatz mit beschichteten Daten- und Versorgungsleitungen; |
| Fig. 3a und Fig. 3b | den Aufbau einer beschichteten Datenleitung; |
| Fig. 3c und Fig. 3d | den Aufbau einer beschichteten Versorgungsleitung; |
| Fig. 4 | die komplexe Permeabilität $\mu$ aufgeteilt in Realteil und Imaginärteil sowie den tan $\delta_\mu$ über der Frequenz; |
| Fig. 5 | die komplexe Permittivität $\varepsilon$ aufgeteilt in Realteil und Imaginärteil sowie den tan $\delta_\varepsilon$ über der Frequenz; |
| Fig. 6 | das Produkt aus Permeabilität $\mu_r$ und Permittivität $\varepsilon_r$ über der Frequenz; |
| Fig. 7 | einen Arbeitsplatz mit einer hochfrequenzmäßig wirksamen Erdung. |

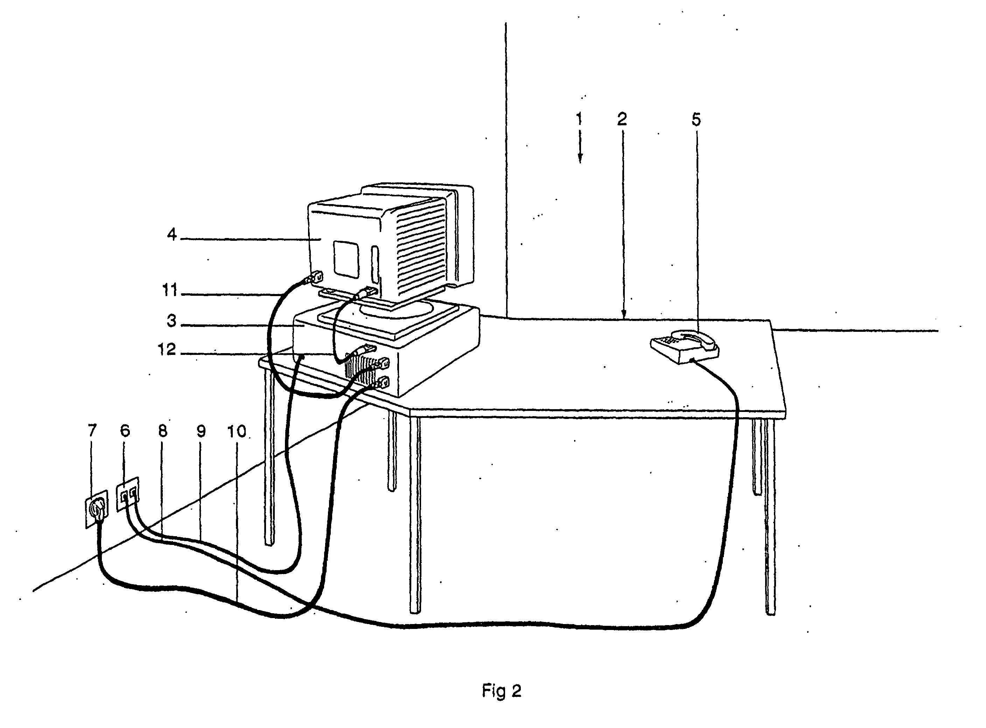

Ein in Fig. 2 dargestellter Arbeitsplatz 1 weist einen Tisch 2 und einen darauf angeordneten Computer 3, einen Bildschirm 4 sowie ein ISDN-Telefon 5 auf. Der Computer wird mit Hilfe einer nicht abgebildeten Tastatur bedient.

In einer nicht näher dargestellten Wand unweit des Tischs 2 befindet sich eine Steckdose 6 des LAN sowie eine herkömmliche Steckdose 7, an der die Netzspannung anliegt. Von der LAN-Steckdose 6 geht eine Datenleitung 8 zum ISDN-Telefon 5 sowie eine Datenleitung 9 zu dem Computer 3. Von der Steckdose 7 verläuft eine Versorgungsleitung 10 zu einem nicht abgebildeten Netzteil des Computers 3. Eine kürzere Versorgungsleitung 11 sowie eine kürzere Datenleitung 12 verbinden den Computer 3 jeweils mit dem Bildschirm 4, um sowohl eine Spannungsversorgung als auch eine Informationsübertragung zu gewährleisten.

Nach der Erfindung sind sowohl die Datenleitungen 8 zum ISDN-Telefon 5, die Datenleitung 9 zum Computer 3 sowie die Datenleitung 12 zwischen Computer 3 und Bildschirm 4 sowie auch die Versorgungsleitungen 10 und 11 mit einer Beschichtung aus einer Kunststoff-Ferrit-Mischung versehen. Die Beschichtung enthält einen Ferritpulveranteil von ca. 60 bis 70 Volumen-% und führt dazu, daß die elektromagnetische Abstrahlung der beschichteten Leitungen minimiert wird.

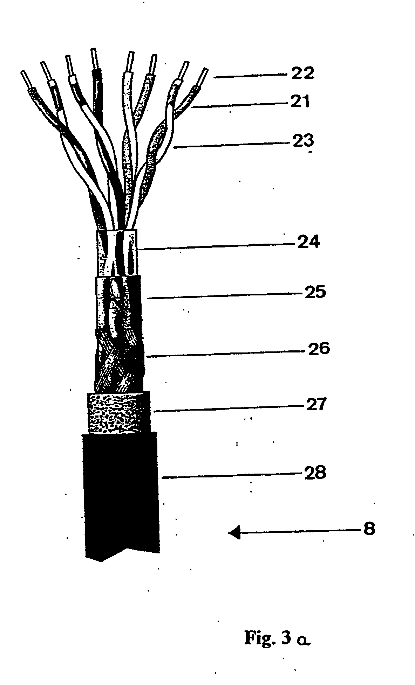

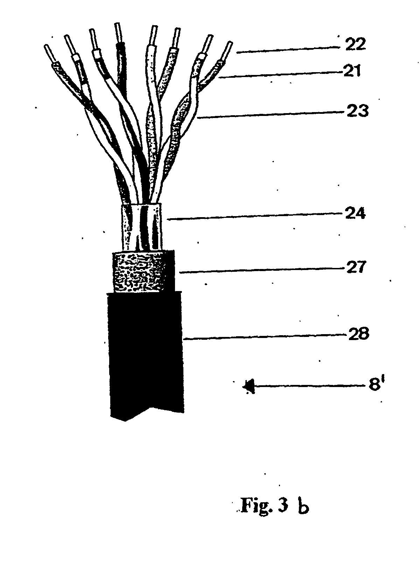

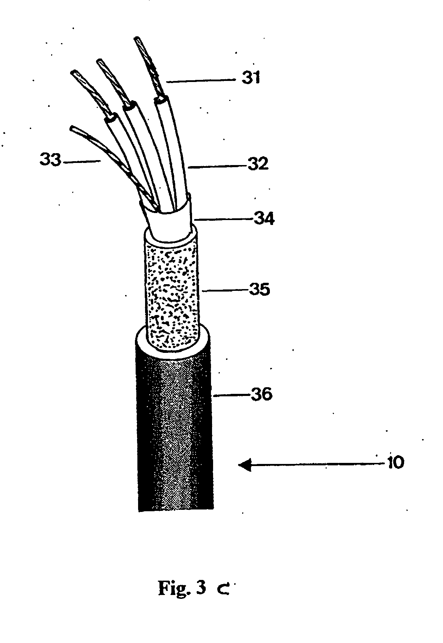

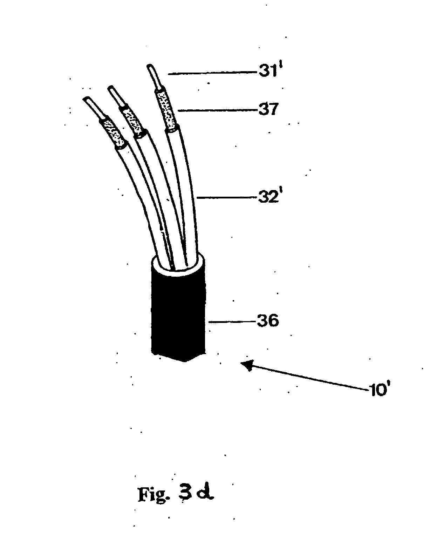

Der Aufbau der Leitungen 8, 9, 10, 11 und 12 ist in den Fig. 3 a bis 3 d erläutert.

Figur 3 a zeigt eine Datenleitung 8, die acht jeweils mit einer Isolation 21 versehene Leiter 22 aufweist. Jeweils zwei der Leiter 22 sind zu einem Paar 23 verdrillt. Die vier Paare 23 sind zu einem Bündel zusammengefaßt und mit einer Kunststoffolie 24 als Trennlage umwickelt. Um diese Kunststoffolie 24 herum befindet sich eine Aluminiumfolie 25, die längslaufend zu der Datenleitung aufgebracht ist und im elektrischen Kontakt zu einem darum angeordneten Geflecht 26 aus dünnen Kupferdrähten steht. Auf dem Geflecht 26 ist eine Beschichtung 27 aufgebracht, die aus in eine Kunststoffmatrix eingebetteten Ferritpartikeln besteht. Die Dicke d der Beschichtung 27 beträgt 0,5 mm, woraus sich ein Produkt ε x μ x d von 90 mm bei einer Frequenz von 1000 MHz bei dem verwendeten Beschichtungsmaterial ergibt. Den äußeren Abschluß bildet ein Mantel 28 aus PVC oder einem halogenfreien Ersatzwerkstoff.

Demgegenüber weist die in Figur 3b dargestellte Datenleitung 8', die wie die Datenleitung 8 als LAN-Datenkabel Verwendung findet, weder eine Aluminiumfolie noch ein Kupferdrahtgeflecht auf. Die Beschichtung 27, deren Dicke wiederum 0,5 mm beträgt, ist in diesem Fall unmittelbar auf die Kunststoffolie 24 aufgebracht und wird nach außen wiederum von einem äußeren Mantel 28 umgeben. Hinsichtlich des inneren Aufbaus ist die Datenleitung 8' mit vier Paaren 23 von verdrillten Leitern 22 mit einer Isolation 21 unverändert gegenüber dem Ausführungsbeispiel gemäß Figur 3 a.

Figur 3 c zeigt eine Versorgungsleitung 10, die wie eine herkömmliche Versorgungsleitung mit drei Leitern 31 versehen ist, die jeweils eine übliche PVC-Isolierung 32 besitzen. Die Leiter 31 sind miteinander sowie mit einem sogenannten Kontaktierleiter 33 verseilt und mit einer äußeren Abschirmung aus einer Aluminiumfolie 34 versehen. Die Aluminiumfolie 34 steht mit dem Kontaktierleiter 33 in elektrischem Kontakt.

Um die Aluminiumfolie herum ist eine Beschichtung 35 aus einem in einer Kunststoffmatrix eingelagerten Ferritmaterial angeordnet. Die ca. 0,5 mm dicke Beschichtung 35 ist außen von einem Mantel 36, beispielsweise aus PVC, umgeben. Der Kontaktierleiter 33 dient zur Erdung der Abschirmung aus Aluminiumfolie 34 und ist üblicherweise zu dem Schutzleiter parallel geschaltet.

Die in Fig. 3 d gezeigte Versorgungsleitung 10' weist keinerlei Abschirmung und auch keinen Kontaktierleiter auf. Die drei Leiter 31' sind jeweils um ihren Kupferkern mit einer Beschichtung 37 aus einer Ferrit-Kunststoffmischung versehen und anschließend von einer Isolation 32' aus PVC umgeben. Die Dicke d der Beschichtung 37 beträgt in diesem Fall ca. 0,4 mm. Daraus ergibt sich ein Produkt von $\varepsilon_r$ x $\mu_r$ x d von ca. 70 mm bei einer Frequenz von 1000 MHz. Während zwei der Leiter 31' der Spannungsversorgung des Gerätes dienen, wird der dritte Leiter 31' zur Schutzerdung des angeschlossenen Geräts verwendet. Die drei Leiter 31' sind miteinander verseilt und mit einem Mantel 36 aus einem Kunststoffmaterial versehen.

Als Werkstoff für die Beschichtung der Leitungen werden vorzugsweise Mischungen aus Ferritpulver und Kunststoffen (PVC, PE oder thermoplastische Elastomere) verwendet. Die Granulometrie des Ferritpulvers weist vorteilhafterweise ein Oberkorn von 200 μm auf. Um einen hohen Volumenfüllgrad von 60 bis 70 % bei der Mischung zu erreichen, ist eine Kornverteilung mit einem ausreichenden Anteil feiner Körner anzustreben. Es können MnZn-Ferrite und ggf. NiZn-Ferrite verwendet werden, die eine ausreichend hohe Permeabilität und Permittivität der Mischung gewährleisten.

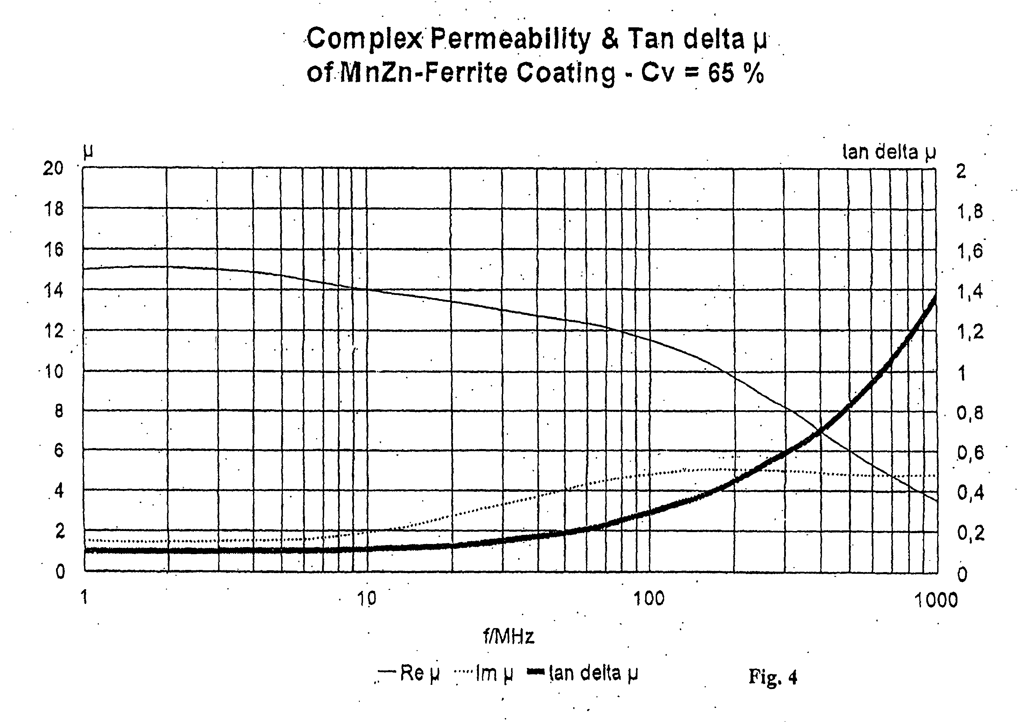

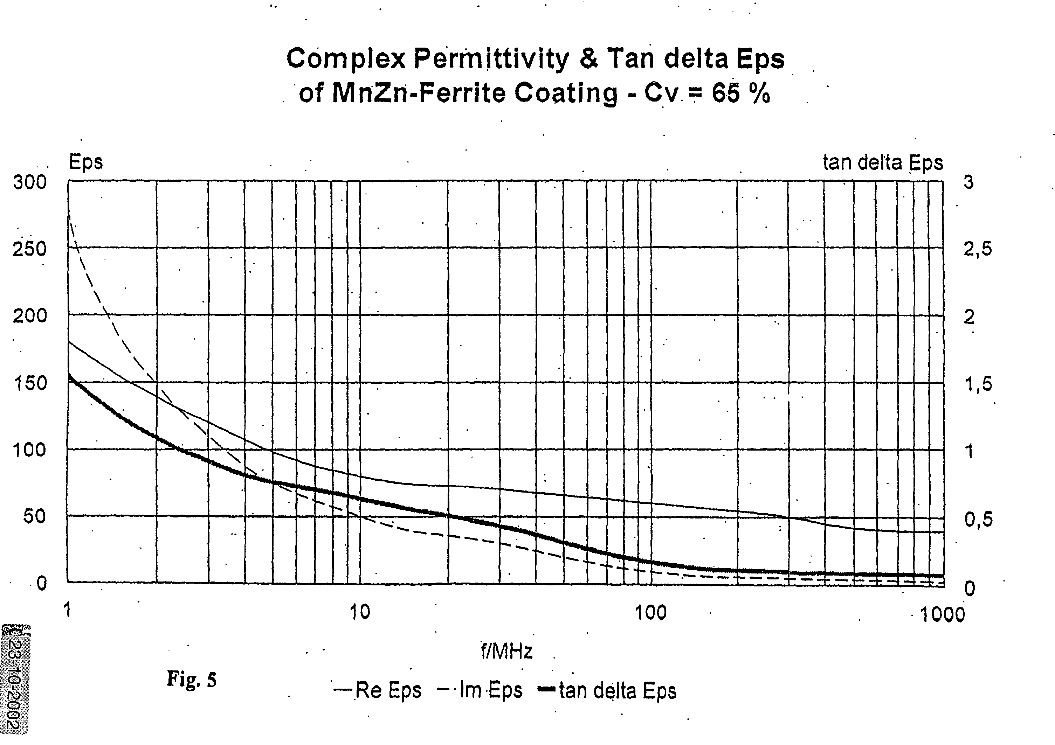

Die Diagramme in den Figuren 4 und 5 zeigen den typischen Verlauf der Permeabilität (Re μ, Im μ) sowie des tan $\delta_\mu$ und der Permittivität (Re ε, Im ε) sowie des tan $\delta_\varepsilon$ einer Mischung mit 65 Volumen-% MnZn-Ferrit und einem thermoplastischen Elastomer als Bindemittel.

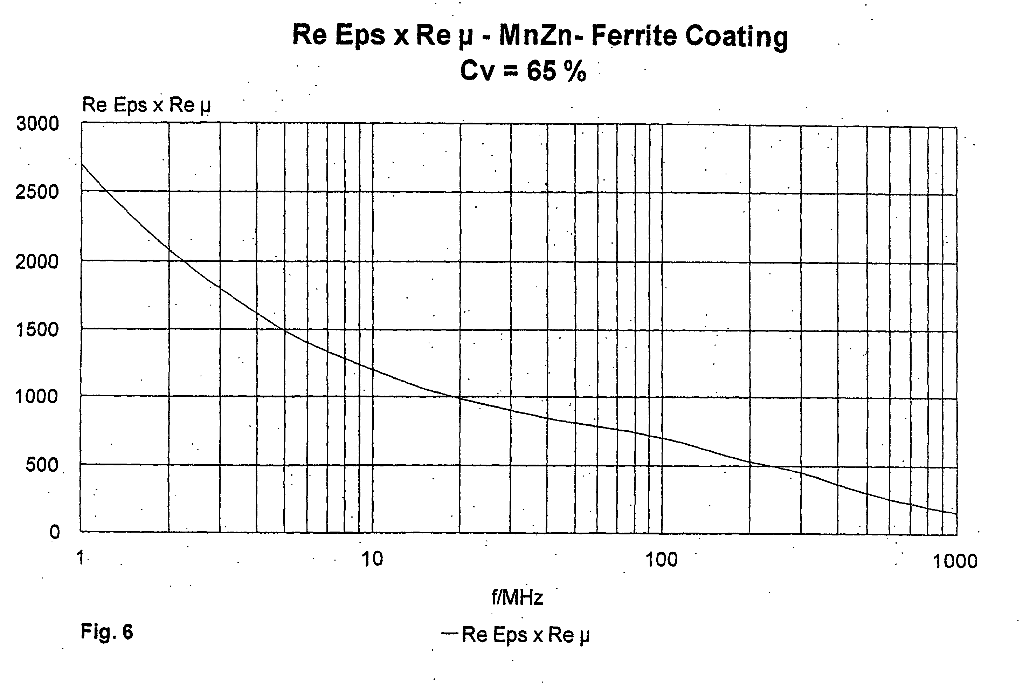

Fig. 6 zeigt den Verlauf des Produkts aus Permeabilität $\mu_r$ und Permittivität $\varepsilon_r$ über der Frequenz. Dem Diagramm läßt sich entnehmen, daß das Produkt $\varepsilon_r$ x $\mu_r$ bis zu einer Frequenz von 1 000 MHz größer als 150 ist. Mit einem derartigen Material ließe sich somit mit Schichtdicken d von lediglich 0,2 mm ein Produkt $\varepsilon_r$ x $\mu_r$ x d größer als 30 mm erzielen.

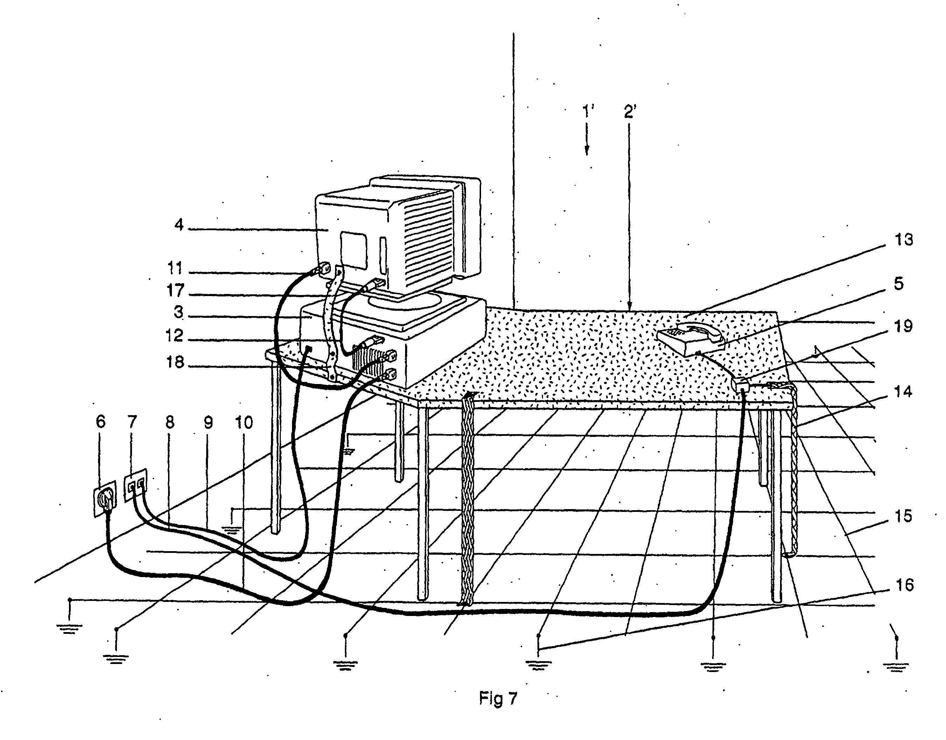

Der, in Fig. 7 dargestellte Arbeitsplatz 1' weist einen Tisch 2' mit einer Arbeitsptatte 13 in Form einer Metallplatte auf. Die Metallplatte ist über mehrere Leiter 14 in Form jeweils eines Kupferbandes mit einem im Boden des Raums befindlichen Leitergitter 15 verbunden. Das Leitergitter 15 ist an einer Mehrzahl von Stellen mit Hilfe von geeigneten Leitern 16 geerdet. Die nicht sichtbaren Metallchassis des Bildschirms 4 sowie des Computers 3 sind über zwei Leiter 17 und 18 jeweils in Form eines Kupferbands mit einer Querschnittsfläche von 50 mm² mit der metallischen Arbeitsplatte 13 verbunden.

In der Zuleitung des ISDN-Telefons 5 befinden sich ganz in der Nähe des Telefons 5 ein Datenfilter und ein Filter für die Stromversorgung. Beide Filter sind in einem gemeinsamen Gehäuse 19 untergebracht. Sie sind als Gleichtaktfilter ausgelegt und stellen eine elektrische Verbindung für die Gleichtaktkomponenten zur Erdung des Arbeitsplatzes her. Im Falle, daß die Leitung mit einer Abschirmung versehen ist, wird diese an dem Daten- und Stromversorgungsfilter geerdet.

Wird auf dem Arbeitsplatz 1' ein sogenannter Laptop-Computer benutzt, wird eine ähnliche Filterung der Gleichtaktkomponenten vorgenommen. Das Stromversorgungsfilter ist in diesem Fall für die Netzspannung ausgelegt.

Bei dem Arbeitsplatz 1' wird die Minimierung der elektromagnetischen Abstrahlung durch eine hochfrequenzmäßig sehr wirksame Erdung, d.h. einen Kurzschluß der "freien" Länge der Anschlußleitungen der Geräte, realisiert, wobei die konkrete Ausführung dieser Anschlußleitungen daher nicht mehr maßgeblich ist und somit Datenund Versorgungsleitungen nach dem Stand der Technik verwendet werden können.

**Patentansprüche**

1. Datenleitung (8, 9, 12) oder Versorgungsleitung (10, 11) für einen Arbeitsplatz (1) mit mindestens einem Gerät in Form eines Computers (3), eines Bildschirms (4), eines Peripheriegeräts oder eines ISDN-Telefons (5), wobei mittels der Datenleitung (8, 9, 12) Daten zu dem Gerät übertragbar sind und die Versorgungsleitung (10, 11) die Spannungsversorgung gewährleistet, **ge*kennzeichnet durch*** ein Material der Beschichtung, wobei das Produkt $\varepsilon_r \times \mu \times d$ aus Dielektrizitätszahl $\varepsilon_r$ des Materials, Permeabilitätszahl $\mu_r$ des Materials und Dicke d der Beschichtung im gesamten Frequenzbereich von Hochfrequenz-Gleichtaktströmen zwischen 1 MHz und 1 000 MHz größer als 30 mm ist.

2. Datenleitung oder Versorgungsleitung nach Anspruch 1, ***dadurch gekennzeichnet, daß*** das Produkt aus Dielektrizitätszahl $\varepsilon_r$, Permeabilitätszahl $\mu_r$ und Dicke d der Beschichtung größer als 50 mm ist.

3. Datenleitung oder Versorgungsleitung nach Anspruch 1 oder 2, ***dadurch gekennzeichnet, daß*** die Datenleitung (8, 9, 12) bzw. die Versorgungsleitung (10, 11 ) von einer gebäudefesten Anschlußstelle bis zu dem Gehäuse des Computers (3), Bildschirms (4), Peripheriegeräts oder ISDN-Telefons (5) durchgängig mit der Beschichtung versehen ist.

4. Datenleitung oder Versorgungsleitung nach einem der Ansprüche 1 bis 3, ***dadurch gekennzeichnet, daß*** die Beschichtung Ferrit enthält.

5. Datenleitung oder Versorgungsleitung nach Anspruch 4, ***dadurch gekennzeichnet, daß*** die Beschichtung aus Ferritpartikeln besteht, die in eine Kunststoffmatrix eingebettet sind.

6. Datenleitung oder Versorgungsleitung nach Anspruch 5, ***dadurch gekennzeichnet, daß*** die Kunststoffmatrix aus PVC, PE oder einem thermoplastischem Elastomer (TPE) besteht.

7. Datenleitung oder Versorgungsleitung nach einem der Ansprüche 1 bis 6, ***dadurch gekennzeichnet, daß*** die Beschichtung im Wege der Extrusion aufgebracht ist.

8. Datenleitung oder Versorgungsleitung nach Anspruch 7, ***dadurch gekennzeichnet, daß*** die Beschichtung unter Druck auf eine Hohlräume aufweisende metallische Abschirmung aufgebracht ist und dabei die Hohlräume zumindest zum Teil ausfüllt.

**Claims**

1. Data line (8, 9, 12) or supply line (10, 11) for a workstation (1) with at least one device in the form of a computer (3), a screen (4), a peripheral device or an ISDN telephone (5), where data can be transferred to the device by means of the data line (8, 9, 12) and the supply line (10, 11) provides the voltage supply, ***characterised by*** a material of the coating, and where the product $\varepsilon_r \ x \ \mu_r \ x \ d$ of the dielectric coefficient $\varepsilon_r$ of the material, permeability coefficient $\mu_r$ of the material and thickness $d$ of the coating is between 1 MHz and 1,000 MHz greater than 30 mm throughout the frequency range of high frequency common mode currents.

2. Data line or supply line according to claim 1, ***characterised in that*** the product of the dielectric coefficient $\varepsilon_r$, permeability coefficient $\mu_r$ and thickness d of the coating is greater than 50 mm.

3. Data line or supply line according to claim 1 or 2, ***characterised in that*** the data line (8, 9, 12) or the supply line (10, 11) is provided with the coating throughout its length from a fixed connection point in a building to the housing of the computer (3), screen (4), peripheral device or ISDN telephone (5).

4. Data line or supply line according to one of claims 1 to 3, ***characterised in that*** the coating contains ferrite.

5. Data line or supply line according to claim 4, ***characterised in that*** the coating consists of ferrite particles which are embedded in a plastic matrix.

**6.** Data line or supply line according to claim 5, ***characterised in that*** the plastic matrix consists of PVC, PE or a thermoplastic elastomer (TPE).

**7.** Data line or supply line according to one of claims 1 to 6, ***characterised in that*** the coating is applied by means of extrusion.

**8.** Data line or supply line according to claim 7, ***characterised in that*** the coating is applied under pressure to a metal screen exhibiting cavities, thereby at least partially filling the cavities.

**Revendications**

**1.** Ligne de données (8, 9, 12) ou ligne d'alimentation (10, 11) pour un poste de travail (1) comportant au moins un appareil se présentant sous la forme d'un ordinateur (3), d'un écran (4), d'un périphérique ou d'un téléphone ISDN (5), des données pouvant être transférées à l'appareil au moyen de la ligne de données (8, 9, 12) et la ligne d'alimentation (10, 11) garantissant l'alimentation en tension, **caractérisée par** un matériau de revêtement, le produit $\varepsilon_r \times \mu_r \times d$ de la permittivité $\varepsilon_r$ du matériau, de la perméabilité $\mu_r$ du matériau et de l'épaisseur d du revêtement étant supérieur à 30 mm dans toute la gamme de fréquences des courants en phase à haute fréquence entre 1 MHz et 1 000 MHz.

**2.** Ligne de données ou ligne d'alimentation selon la revendication 1, **caractérisée en ce que** le produit de la permittivité $\varepsilon_r$, de la perméabilité $\mu_r$ et de l'épaisseur d du revêtement est supérieur à 50 mm.

**3.** Ligne de données ou ligne d'alimentation selon la revendication 1 ou 2, **caractérisée en ce que** la ligne de données (8, 9, 10), resp. la ligne d'alimentation (10, 11), est doté du revêtement d'un bout à l'autre d'une borne de raccordement fixe d'un édifice jusqu'au boîtier de l'ordinateur (3), de l'écran (4), du périphérique ou du téléphone ISDN (5).

**4.** Ligne de données ou ligne d'alimentation selon l'une des revendications 1 à 3, **caractérisée en ce que** le revêtement contient du ferrite.

**5.** Ligne de données ou ligne d'alimentation selon la revendication 4, **caractérisée en ce que** le revêtement se compose de particules de ferrite qui sont incorporées dans une matrice de matière plastique.

**6.** Ligne de données ou ligne d'alimentation selon la revendication 5, **caractérisée en ce que** la matrice de matière plastique se compose de PVC, de PE ou d'un élastomère thermoplastique (TPE).

**7.** Ligne de données ou ligne d'alimentation selon l'une des revendications 1 à 6, **caractérisée en ce que** le revêtement est appliqué par extrusion.

**8.** Ligne de données ou ligne d'alimentation selon la revendication 5, **caractérisée en ce que** le revêtement est appliqué sous pression sur un blindage métallique comportant des espaces creux et remplit donc au moins partiellement les espaces creux.

Handbook of Biological Effects of Electromagnetic Fields (fig. 31, p. 380)

Fig 1

EP 1 117 285 B1

Fig 2

22
21
23
24
25
26
27
28
8

Fig. 3 a

Fig. 3 b

Fig. 3

—31'

—37

—32'

—36

—10'

Fig. 3 d

Complex Permeability & Tan delta μ of MnZn-Ferrite Coating - Cv = 65 %

Fig. 4

## Complex Permittivity & Tan delta Eps of MnZn-Ferrite Coating - Cv = 65 %

**Fig. 5**

—Re Eps  — Im Eps  —tan delta Eps

f/MHz

EP 1 117 285 B1

Re Eps x Re µ - MnZn- Ferrite Coating
Cv = 65 %

Fig. 6

Fig 7